# EUROPEAN PATENT APPLICATION

(11) **EP 4 379 642 A1**
(43) Date of publication of application: **05.06.2024**
(21) Application number: 22856052.0
(22) Date of filing: 21.07.2022
(51) Int. Cl.: G06Q 50/06, H02J 3/14, H02J 3/00, G01D 21/02, G01R 22/06, G08B 21/18, H04H 20/59

(54) **ENERGY MANAGEMENT SYSTEM FOR NATIONAL POWER GRID DEMAND MANAGEMENT AND BLACKOUT PREVENTION, AND OPERATION METHOD THEREOF**

(30) Priority: 13.08.2021 KR 20210107380
(71) Applicant: Kim, Eun Tae, Jeju-do 63119 (KR)
(72) Inventor: Kim, Eun Tae, Jeju-do 63119 (KR)
(74) Representative: Acorn IP LLP
(86) International application number: PCT/KR2022/010661
(87) International publication number: WO 2023/018051

(57) **Abstract**

The present invention relates to: an energy management system for small-scale demand management and large-scale blackout prevention, which manages power supply and demand situations by cutting off power being supplied to customers step by step on the basis of power consumption data of each customer by house and region and power reserve rate data; and an operation method thereof. A small-scale demand management system according to the present invention is installed in a system of a demand management business operator, controls and restores forced power supply of a contracted house, building, factory, or the like when the demand for power surges, and comprises a demand management apparatus for a DR, a national DR, an automatic DR, and the like. The energy management system according to the present invention comprises: a smart distribution board that is installed in a central power control system and a power management organization, and includes a relay for an EMS, which controls a circuit breaker for regular power supply, which is not cut off when a power emergency situation occurs, and a circuit breaker for forced power supply that is power supply that can be cut off when a power emergency situation occurs; and an energy management apparatus that controls the relay for an EMS of the smart distribution board when a power emergency situation occurs, accumulatively stores power consumption data of each consumer by house and region and power reserve rate data, when a power emergency situation occurs, sequentially cuts off, on the basis of the accumulated power consumption data and power reserve rate data, power being supplied to each consumer, and restores the relay for an EMS when the power emergency situation is resolved.

## Description

### TECHNICAL FIELD

The present invention relates to an energy management system, and more specifically, to an energy management system for managing nationwide power grid demand and preventing blackout and an operation method thereof, which manages demands for small-scale power in homes, buildings, and factories where a specific smart distribution board is installed, and manages power supply and demand situations by cutting off power supplied to consumers step by step on the basis of power consumption data and nationwide power reserve rate data.

### BACKGROUND ART

Recently, demand for electrical power is rapidly increasing due to the use of heating and cooling devices in summer and winter and expansion of electric vehicles.

In addition, according to an announcement made by the Korea Energy Agency, standby power of existing houses is 11%, and as smart home platform products such as remote controls, sensors, artificial intelligence devices, and IoT device-based networks are distributed together with rapid growth of the smart home and building market, a large amount of standby power is generated.

Recently, blackouts such as the blackout in New York in 1965, blackout in North American in 2003, blackout in Brazil in 2009, regional rotation blackout in Korea and blackout in Fukushima Japan in 2011, blackout in South Australia in 2016, blackout in Taiwan in 2017, blackout in Hokkaido Japan in 2018, blackout in Venezuela, Uruguay, and Argentina in 2019, blackout in Texas US and Taiwan in 2021, and the like are increasing rapidly around the world.

Seeing the causes of these power outages, although there are various causes such as overload of transmission lines, failure of power plants, human errors, paralysis of power grid infrastructures according to occurrence of typhoons, and disasters such as earthquakes, the biggest reason is absence of original technology for preventing blackouts until present.

Here, the blackout refers to a state in which all power systems suddenly stop due to lack of electricity, or such a phenomenon. The blackout refers to a large-scale power outage, usually a case of completely losing power in a specific region.

In Korea, an unprecedented power outage occurred on September 15, 2011 across the country including Gangnam and Yeouido in Seoul, Gyeonggi, Gangwon, Chungcheong and the like, except Jeju. The power outage that began at 3:10 p.m. on this day was recovered only at 7:56 p.m., about 5 hours later, and the scale of power outage reached a maximum of 1.62 million locations nationwide, and the damage is estimated as much as 61 billion Korean Won.

In order to prevent occurrence of damage according to the blackouts, the central power control center of Korea Power Exchange identifies the amount of reserve power and classifies corresponding power supply and demand situations into five stages: 'preparation, interest, caution, alert, and serious', and when a 'serious' situation occurs, the central power control center requests a regional rotation power outage from Korea Electric Power Corporation (KEPCO) to manage the power supply and demand situation.

The regional rotation power outage is a method of reducing power consumption by selecting regions of high power consumption and forcing power outages. At this point, the power outage regions are changed every 30 minutes or 1 hour to prevent occurrence of damage from the power outage only in a specific region.

In this case, an equity problem occurs as people located in a region where the rotation power outage is implemented suffer from damage of the power outage, while people in other regions do not suffer from the damage. In addition, since the power outage is implemented in the entire area of a specific region even when the amount of reserve power is slightly lower than a preset value, there is also a problem of excessively implementing power outages by cutting off power of consumers more than necessary.

### DISCLOSURE OF INVENTION

### TECHNICAL PROBLEM

Therefore, an object of the present invention is to provide an energy management system for preventing blackouts and an operation method thereof, which manages power supply and demand situations by cutting off power supplied to consumers step by step by utilizing IoT communication networks on the basis of small-scale power consumption data and power reserve rate data using IoT communication networks of homes, buildings, and factories where specific smart distribution boards are installed across the country.

A specific smart distribution board is a distribution board that separates circuit breakers into groups of circuit breakers for regular power supply and circuit breakers for forced power supply, and includes a relay dedicated to an Energy Management System (EMS) that may control the forced power supply when a power emergency situation occurs. People may remotely control the forced power supply of homes, buildings, and factories for various purposes through apps and the web on the basis of the distribution boards, and in addition, power demand management business operators may run power demand management businesses such as DR, national DR, and the like, and the government may prevent blackouts when a power emergency situation occurs on the basis of a smart distribution board equipped with a relay dedicated to the Energy Management System (EMS).

### TECHNICAL SOLUTION

An energy management system according to the present invention may be installed in the Korea Power Exchange Central Power Control Center, Korea Electric Power Corporation, and other specific power management organizations as needed, and includes smart distribution boards of houses, buildings, and factories equipped with a relay for an energy management system (EMS) that controls groups of circuit breakers for regular power supply that does not cut off even when a power emergency situation occurs and circuit breakers for forced power supply that can be cut off when a power emergency situation occurs.

A power demand management system is a power demand management system based on weather, fine dust, and power consumption data when small-scale demand management is required as expansion of electric vehicle supply and abrupt increase in demand for electricity in summer and winter are expected, and includes systems such as DR, national DR, auto DR, and the like that control EMS relays for circuit breakers for forced power of consumers such as apartments, buildings, and factories contracted with a power demand management operator.

The energy management system for preventing blackouts includes an energy management apparatus that controls the EMS relay of a smart distribution board when a power emergency situation occurs in order to accumulatively store power consumption data of each consumer and power reserve rate data by house and region, sequentially cut off power supplied to each consumer on the basis of the accumulated power consumption data and power reserve rate data when a power emergency situation occurs, and restore the EMS relay when the power emergency situation is resolved.

In the energy management system according to the present invention, the energy management system includes a communication unit for transmitting and receiving control and recovery commands to and from the smart distribution board; a storage unit for storing the power consumption data and the power reserve rate data; and a control unit for controlling the EMS relay of the smart distribution board through the communication unit when a power emergency situation occurs to sequentially cut off power supplied to each consumer on the basis of the power consumption data stored in the storage unit, and restore the EMS relay when the power emergency situation is resolved.

In the energy management system according to the present invention, the communication unit performs data transmission and reception with the smart distribution board through an IoT communication network.

In the energy management system according to the present invention, the control unit collects and analyzes the power consumption data stored in the storage unit at preset intervals, processes and stores the power consumption data step by step in order of high power consumption by the type of each consumer, and controls each consumer step by step by the type by comparing the processed data with the power reserve rate in real time.

In the energy management system according to the present invention, the control unit predicts a power cutoff priority of each consumer, a power cutoff priority of each consumer type, and a power cutoff priority of each region according to each consumer through an artificial intelligence engine trained using the power consumption data and the power reserve rate data stored in the storage unit, and sequentially cuts off power supplied to each consumer step by step according to one of the predicted cutoff priorities.

In the energy management system according to the present invention, when the EMS relay of each consumer is controlled, the control unit transmits text of control details in real time to terminals possessed by residents, managers, and owners living in the control target consumer region, and transmits a blackout situation and the control details to a broadcasting company so that subtitles may be broadcasted.

An energy management method according to the present invention includes the steps of: accumulatively storing power consumption data of each consumer and power reserve rate data; controlling EMS relays of smart distribution boards installed in a central power control center and a power management organization when a power emergency situation occurs, including an EMS relay for controlling forced power supply that can be cut off when a power emergency situation occurs, in order to sequentially cut off power supplied to each consumer on the basis of the accumulated power consumption data and power reserve rate data; and restoring the EMS relay when the power emergency situation is resolved.

### ADVANTAGEOUS EFFECTS

As the present invention accumulatively stores power consumption data of each consumer and power reserve rate data, determines priorities for cutting off power of consumers when a power emergency situation occurs through an artificial intelligence engine trained on the basis of the accumulated power consumption data and power reserve rate data, and sequentially cuts off power supplied to each consumer step by step, safety of power system operation, such as management of small-scale demands and prevention of large-scale blackouts, can be secured in preparation for disasters, and as it can be used as a national lighting control system during a war and may shut down coal power plants in normal times as people save electricity on the basis of smart distribution boards, it may lead carbon emission neutrality as an original technology that will greatly reduce greenhouse gases such as fine dust, CO₂, and the like according thereto.

In addition, as consumers such as homes, buildings, and factories that are forced to cut off power when a power emergency situation occurs are allowed to use regular power, damage to the consumers can be reduced by using essential power even in a nationwide power emergency situation.

### BRIEF DESCRIPTION OF THE DRAWINGS

FIG. 1 is a block diagram showing the configuration of an energy management system according to an embodiment of the present invention.
FIG. 2 is a block diagram showing the configuration of an energy management apparatus according to an embodiment of the present invention.
FIG. 3 is a block diagram specifically showing the configuration of a control unit according to an embodiment of the present invention.
FIG. 4 is a block diagram specifically showing an estimation module according to an embodiment of the present invention.
FIG. 5 is a view for explaining the configuration of a deep neural network (DNN) according to an embodiment of the present invention.
FIG. 6 is a flowchart illustrating an energy management method according to an embodiment of the present invention.
FIG. 7 is a flowchart illustrating an example of an energy management method according to an embodiment of the present invention.

### BEST MODE FOR CARRYING OUT THE INVENTION

It should be noted that in the following description, only the parts thar are needed to understand the embodiments of the present invention will be described, and description of other parts will be omitted so as not to distract the gist of the present invention.

Terms and words used in the specification and claims described below should not be interpreted as being limited to their usual or dictionary meanings, and the terms and words should be interpreted as a meaning and concept that matches the technical spirit of the present invention on the basis of the principle that inventors may appropriately define the concept of the terms in order to explain their inventions in the best way. Accordingly, the embodiments described in this specification and the configurations shown in the drawings are only preferred embodiments of the present invention and do not represent the entire technical spirit of the present invention, and therefore, it should be understood that there may be various equivalents and modifications that can replace them at the time of filing this application.

The present invention relates to a system for managing power supply and demand situations. Hereinafter, embodiments of the present invention will be described in more detail with reference to the attached drawings.

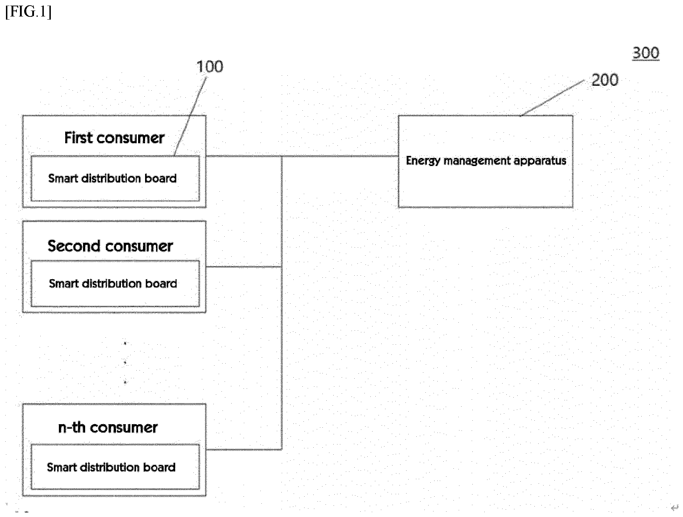

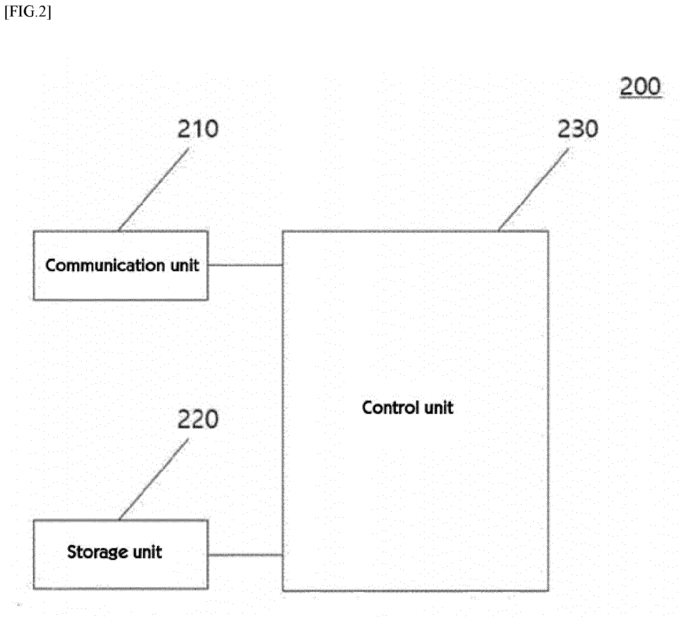

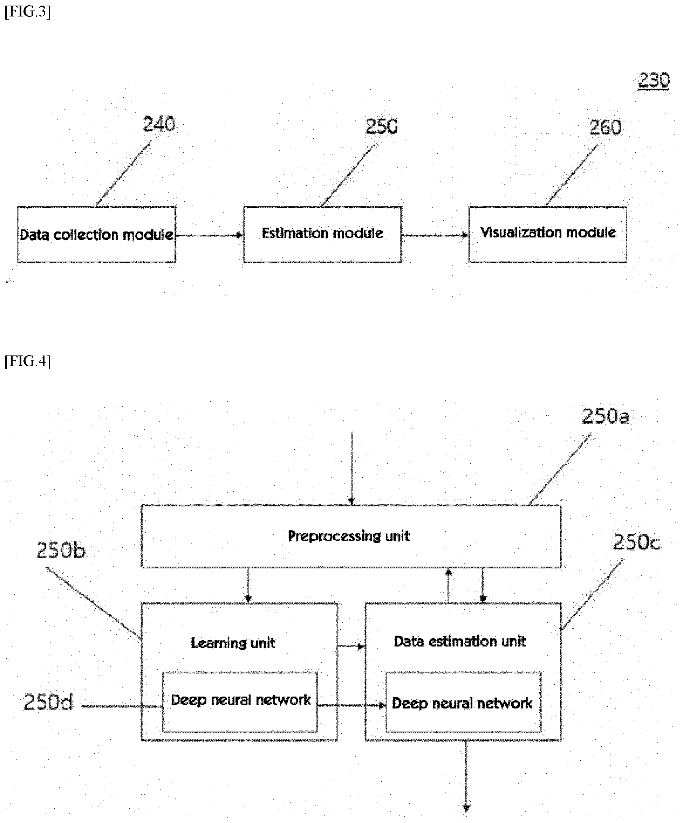

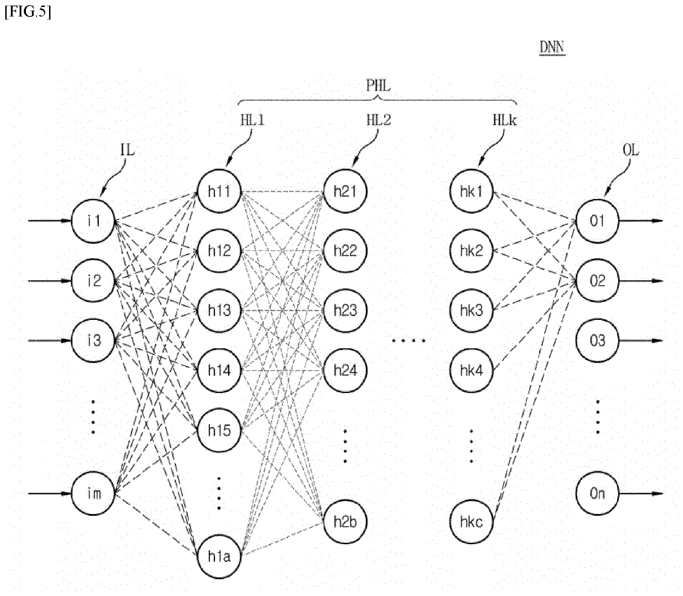

FIG. 1 is a block diagram showing the configuration of an energy management system according to an embodiment of the present invention, FIG. 2 is a block diagram showing the configuration of an energy management apparatus according to an embodiment of the present invention, FIG. 3 is a block diagram specifically showing the configuration of a control unit according to an embodiment of the present invention, FIG. 4 is a block diagram specifically showing an estimation module according to an embodiment of the present invention, and FIG. 5 is a view for explaining the configuration of a deep neural network (DNN) according to an embodiment of the present invention.

Referring to FIGS. 1 to 5, an energy management system 300 according to an embodiment of the present invention includes a plurality of smart distribution boards 100 provided in each consumer, and an energy management apparatus 200.

The smart distribution board 100 includes an EMS relay that controls a circuit breaker for regular power supply that is installed at each consumer and is not cut off even when a power emergency situation occurs, and a circuit breaker for forced power supply that can be cut off when a power emergency situation occurs.

That is, the smart distribution board 100 includes an EMS relay, which controls a circuit breaker for regular power supply that starts and stops supply of power to loads with relatively high importance of power supply, and a circuit breaker for forced power supply that starts and stops supply of power to loads with relatively low importance of power supply.

For example, a relay for a regular power supply is a relay for supplying essential power of houses, buildings, factories, or the like, and may correspond to a power supply for emergency lights, refrigerators, rice cookers, or the like in the case of houses, correspond to a power supply for elevators, computing servers, data systems, or the like in the case of buildings, or correspond to a power supply for operating elevators, computing servers, important processes in the case of factories, which is a power supply that cannot be cut off in this system. On the contrary, the EMS relay is a relay that may cut off all power supplies other than the regular power supply in the event of a nationwide power emergency.

In the smart distribution board 100, the EMS relay may be cut off, or an EMS relay that has been cut off may be restored, under the control of the energy management apparatus 200.

In addition, the circuit breaker for regular power supply of the smart distribution board 100 is designed not to be controlled in any circumstances since it connects the essential power supply of consumers.

The energy management apparatus 200 controls the EMS relay of the smart distribution board 100 when a power emergency situation occurs, and may accumulatively store power consumption data of each consumer, sequentially cut off power supplied to each consumer on the basis of the accumulated power consumption data when a power emergency situation occurs, and restore the EMS relay when the power emergency situation is resolved.

Particularly, the energy management apparatus 200 adopts a convergence technique that utilizes ICABMS (IoT, cloud, AI, big data, mobile, security) and may control the smart distribution board 100 of each consumer regionally and nationwide, step by step or simultaneously throughout the entire country in the worst case, on the basis of data collected, analyzed, processed, and stored in association with power consumption data of each consumer and region in the country and power reserve rate data provided by the power control center.

The energy management apparatus 200 like this may include a communication unit 210, a storage unit 220, and a control unit 230.

The communication unit 210 is a component for transmitting and receiving information through communication networks, and is provided with a communication interface for performing wired or wireless communication according to the types of communication networks.

The communication unit 210 receives information on power consumption of consumers and power reserve rates collected by power management organizations such as the Korea Power Exchange or Korea Electric Power Corporation, and transmits the information to the control unit 40. In addition, the communication unit 10 may transmit a signal for cutting off the power supplied to the consumer under the control of the control unit 40. Here, the communication unit 210 may transmit a signal for controlling the EMS relay included in the smart distribution board 100 of each consumer on the basis of IoT communication networks.

The storage unit 220 stores the power consumption data of each consumer and power reserve rate data by house and region. Particularly, the storage unit 220 stores information on the types that classify consumers who use power according to their characteristics, and continuously collects and stores information on power consumption of consumers classified to be included in each type of consumers. In addition, the storage unit 220 receives and continuously stores power reserve rate information from power management organizations. That is, the storage unit 220 may construct big data by continuously collecting and analyzing power consumption data and power reserve rate data. At this point, the storage unit 220 may store the data through cloud systems.

The control unit 230 controls the EMS relay of the smart distribution board 100 through the communication unit 210, and may cut off the EMS relay when a power emergency situation occurs on the basis of power consumption data of each consumer and the power reserve rate data stored in the storage unit 220, and restore the EMS relay when the power emergency situation is resolved.

In addition, the control unit 230 analyzes the power consumption data stored in the storage unit 220 at preset intervals, processes and stores the power consumption data step by step in order of high power consumption by the type of each consumer, and controls each consumer step by step by the type by comparing the processed data with the power reserve rate in real time. At this point, power consumption of each consumer may be an average of previously stored power consumption.

For example, the control unit 230 may compare power consumption of each house, group houses of high power consumption into 5 levels of 20% each, and store them in the storage unit 220. In addition, the control unit 230 may group buildings of high power consumption into 5 levels of 20% each for each building and store them in the storage unit 220. In addition, the control unit 230 may group factories of high power consumption into 5 levels of 20% each for each factory and store them in the storage unit 220.

In addition, the control unit 230 may compare in real time whether a preset power reserve rate is satisfied according to the step-by-step control of each stored consumer, and control each consumer step by step according to a result of the comparison.

In addition, the control unit 230 may predict a power cutoff priority of each consumer, a power cutoff priority of each consumer type, and a power cutoff priority of each region according to each consumer through an artificial intelligence engine trained using the power consumption data and the power reserve rate data stored in the storage unit 220, and sequentially cut off power supplied to each consumer step by step according to one of the predicted cutoff priorities.

Here, the control unit 230 includes a data collection module 240, an estimation module 250, and a visualization module 260.

The data collection module 240 may collect power consumption data collected from each consumer and power reserve rate data collected from power control centers.

The estimation module 250 may perform deep learning on a deep neural network (DNN) using the data stored in the data collection module 240 when the power consumption data of each consumer and the power reserve rate data are input, and predict a power cutoff priority of each consumer, a power cutoff priority of each consumer type, and a power cutoff priority of each region according to each consumer using the deep neural network (DNN) trained in this way. Meanwhile, although the present invention is explained in the following description that a deep neural network is trained, it is not limited thereto, and various algorithms related to machine learning may be applied.

The visualization module 260 may visualize the power cutoff priority of each consumer, the power cutoff priority of each consumer type, and the power cutoff priority of each region according to each consumer estimated by the estimation module 250 as a table or a graph.

Next, the estimation module 250 will be described in more detail. The estimation module 250 includes a preprocessing unit 250a, a learning unit 250b, and a data estimation unit 250c.

When power consumption data of each consumer and power reserve rate data are input, the preprocessing unit 250a preprocesses the data as input variables for estimating a power cutoff priority of each consumer, a power cutoff priority of each consumer type, and a power cutoff priority of each region according to each consumer, and provides the priorities to the learning unit 250b or the data estimation unit 250c.

The learning unit 250b trains the deep neural network (DNN) that estimates the power cutoff priority of each consumer, the power cutoff priority of each consumer type, and the power cutoff priority of each region according to each consumer using the power consumption data of each consumer and the power reserve rate data.

Here, the deep neural network (DNN) may be a multilayer perceptron (MLP). The deep neural network (DNN) includes a plurality of layers (IL, HL, OL). The plurality of layers includes an input layer (IL), a plurality of hidden layers (HL: HL1 to HLk), and an output layer (OL).

In addition, each of the plurality of layers IL, HL, and OL includes a plurality of nodes. For example, as shown in FIG. 5, the input layer IL may include m input nodes i1 to im, and the output layer OL may include n output nodes o1 to on. In addition, among the hidden layers HL, a first hidden layer HL1 may include 'a' nodes h11 to h1a, a second hidden layer HL2 may include 'b' nodes h21 to h2b, and a k-th hidden layer HL2 may include 'l' nodes hk1 to hkc.

Each of the plurality of nodes in the plurality of layers performs an operation. In particular, a plurality of nodes in different layers is connected through channels (indicated by dotted lines) each having a weight value (W). In other words, a weight value is applied to an operation result of any one node to produce an input of a node in the next layer. That is, any one node in any one layer of the deep neural network (DNN) receives a value produced by applying a weight value to the input from a node in a previous layer, adds them and takes an activation function, and passes the result as an input of the next layer.

Accordingly, when power consumption data of each consumer and power reserve rate data are input into the input layer (IL) of the deep neural network (DNN), the deep neural network (DNN) performs a plurality of operations of applying a weight value of a plurality of measurements (IL, HL, OL) to the input data to produce an output value indicating a power cutoff priority of each consumer, a power cutoff priority of each consumer type, and a power cutoff priority of each region according to each consumer.

Here, the power consumption data of each consumer and the power reserve rate data may be input variables.

The power cutoff priority of each consumer, the power cutoff priority of each consumer type, and the power cutoff priority of each region according to each consumer may be output variables.

Describing in more detail, when power consumption data of each consumer and power reserve rate data are input into a plurality of input nodes i1 to im of the input layer IL of the deep neural network (DNN), each of the first hidden nodes h11 to h1a of the first hidden layer HL1 receives a value produced by applying a weight value to each process analysis result value of a plurality of input nodes i1 to im (indicated by dotted lines), sums up all the input values, and produces a plurality of first hidden node values by performing an operation according to an activation function on the summed value. Subsequently, each of the second hidden nodes h21 to h2b of the second hidden layer HL2 receives a value produced by applying a weight value to each of the plurality of first hidden node values of the plurality of first hidden nodes h11 to h1a (indicated by dotted lines), sums up all the input values, and produces a plurality of second hidden node values by performing an operation according to an activation function on the summed value. In this way, a previous node value is applied with a weight value and passed within the hidden layer (HL), and a current node value is calculated through an operation. By repeating this process, a plurality of k-th hidden node values of a plurality of k-th hidden nodes hk1 to hkl of the k-th hidden layer HLk can be calculated.

Each of the output nodes o1 to on receives a value produced by applying a weight value w=[w1, w2, ..., wl] to a plurality (1) k-th hidden node values of a plurality of k-th hidden nodes hk1 to hkl of the k-th hidden layer HKl (indicated by dotted lines), sums up all the input values, and produces an output value by performing an operation according to an activation function on the summed value.

Each of the n output nodes o1 to on of the output layer OL may correspond to at least one among the power cutoff priority of each consumer, the power cutoff priority of each consumer type, and the power cutoff priority of each region according to each consumer. As described, according to an embodiment of the present invention, the trained deep neural network (DNN) calculates an output value by performing a plurality of operations of applying a weight value of a plurality of layers (IL, HL, OL) to the input data.

In addition, when the EMS relay of each consumer is controlled, the control unit 230 transmits text of control details in real time to terminals possessed by residents, managers, and owners living in the control target consumer region, and transmits the control details to a broadcasting company so that subtitles may be broadcasted.

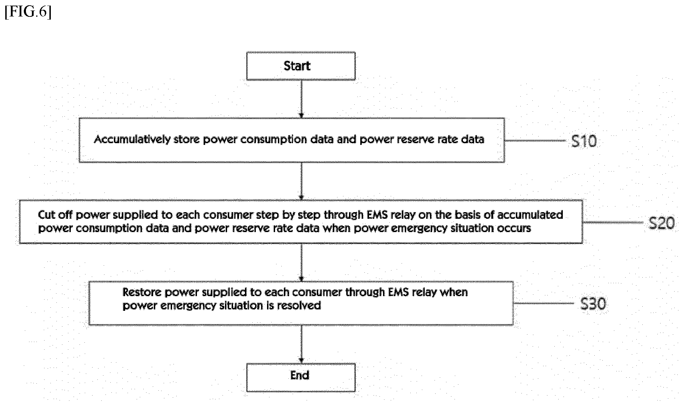

Hereinafter, an energy management method according to an embodiment of the present invention will be described. FIG. 6 is a flowchart illustrating an energy management method according to an embodiment of the present invention.

Referring to FIG. 6, first, at step S10, the energy management apparatus accumulatively stores power consumption data of each consumer and power reserve rate data. Here, the energy management apparatus stores information on the types that classify consumers who use power according to their characteristics, and continuously collects and stores information on power consumption of consumers classified to be included in each type of the consumers. In addition, the energy management apparatus receives and continuously stores power reserve rate information from power management organizations. That is, the energy management apparatus may construct big data by continuously collecting power consumption data and power reserve rate data. At this point, the energy management apparatus may store the data through cloud systems.

Then, at step S20, the energy management apparatus is installed in the central power control center and the power management organization, and controls EMS relays of the smart distribution board including a circuit breaker for regular power supply that is not cut off even when a power emergency situation occurs and a circuit breaker for forced power supply that can be cut off when a power emergency situation occurs, in order to sequentially cut off power supplied to each consumer on the basis of the accumulated power consumption data and power reserve rate data.

Here, at step S10, the energy management apparatus collects and analyzes the stored power consumption data at preset intervals, processes and stores the power consumption data step by step in order of high power consumption by the type of each consumer, and controls each consumer step by step by the type by comparing the processed data with the power reserve rate in real time. At this point, power consumption of each consumer may be an average of previously stored power consumption.

For example, the energy management apparatus may compare power consumption of each house, and group and store houses of high power consumption into 5 levels of 20% each. In addition, the energy management apparatus may group and store buildings of high power consumption into 5 levels of 20% each for each building. In addition, the energy management apparatus may group and store factories of high power consumption into 5 levels of 20% each for each factory.

In addition, the energy management apparatus may compare in real time whether a preset power reserve rate is satisfied according to the step-by-step control of each stored consumer, and control each consumer step by step according to a result of the comparison.

In addition, the energy management apparatus may predict a power cutoff priority of each consumer, a power cutoff priority of each consumer type, and a power cutoff priority of each region according to each consumer through an artificial intelligence engine trained using the stored power consumption data and power reserve rate data, and sequentially cut off power supplied to each consumer step by step according to one of the predicted cutoff priorities.

At this point, when the EMS relay of each consumer is controlled before the power is cut off, the energy management apparatus transmits text of control details in real time to terminals possessed by residents, managers, and owners living in the control target consumer region, and transmits the control details to a broadcasting company so that subtitles may be broadcasted.

In addition, at step S30, the energy management apparatus restores the EMS relay when the power emergency situation is resolved. At this point, the energy management apparatus may restore the EMS relay of each smart distribution board in the reverse order of cutting off the power.

The power supply and demand management method for preventing blackouts according to an embodiment of the present invention may be implemented in the form of a program that can be read through various computer means and recorded on a computer-readable recording medium.

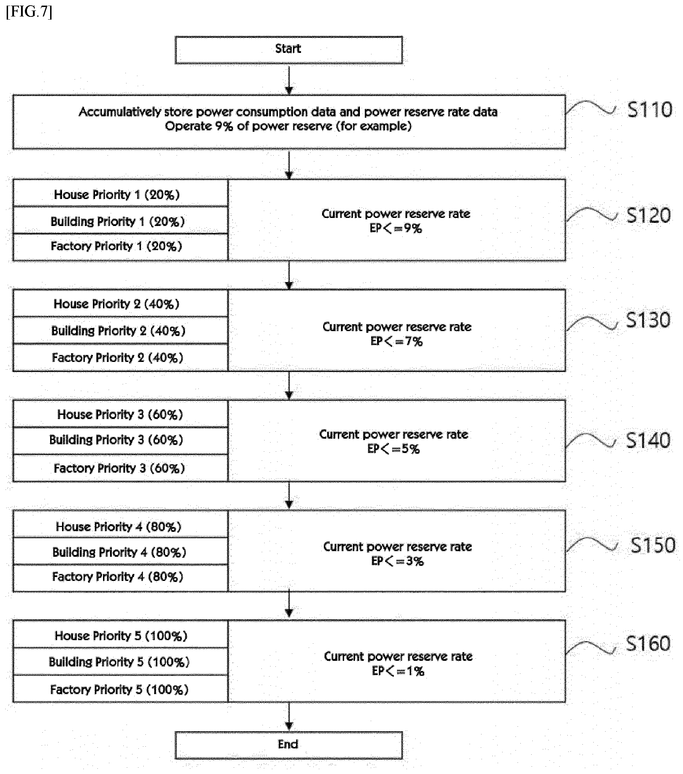

FIG. 7 is a flowchart illustrating an example of an energy management method according to an embodiment of the present invention.

Referring to FIG. 7, at step S110, the energy management apparatus accumulatively stores power consumption data of each consumer and power reserve rate data by house and region.

Next, at step S120, when the power reserve rate (EP) drops below 9%, the energy management apparatus collects and analyzes the stored power consumption data, and controls the first stage of cutting off power for 20% of houses, 20% of buildings, and 20% of factories with high power consumption through the data processed by the type of each consumer, step by step in order of high power consumption.

Next, at step S130, when the power reserve rate (EP) drops below 7%, the energy management apparatus collects and analyzes the stored power consumption data, and controls the second stage of cutting off power for 40% of houses, 40% of buildings, and 40% of factories with high power consumption through the data processed by the type of each consumer, step by step in order of high power consumption.

Next, at step S140, when the power reserve rate (EP) drops below 5%, the energy management apparatus collects and analyzes the stored power consumption data, and controls the third stage of cutting off power for 60% of houses, 60% of buildings, and 60% of factories with high power consumption through the data processed by the type of each consumer, step by step in order of high power consumption.

Next, at step S150, when the power reserve rate (EP) drops below 3%, the energy management apparatus collects and analyzes the stored power consumption data, and controls the fourth stage of cutting off power for 80% of houses, 80% of buildings, and 80% of factories with high power consumption through the data processed by the type of each consumer, step by step in order of high power consumption.

Next, at step S160, when the power reserve rate (EP) drops below 1%, the energy management apparatus collects and analyzes the stored power consumption data, and controls the fifth stage of cutting off power for 100% of houses, 100% of buildings, and 100% of factories with high power consumption through the data processed by the type of each consumer, step by step in order of high power consumption.

Meanwhile, the embodiments disclosed in the specification and drawings are merely provided as specific examples to help understanding, and are not intended to limit the scope of the present invention. It is obvious to those skilled in the art that other modifications based on the technical spirit of the present invention can be embodied, in addition to the embodiments disclosed herein. In addition, although specific terms are used in the specification and drawings, they are used in a general sense only to easily explain the technical content of the present invention and help understanding of the present invention, and are not intended to limit the scope of the present invention.

### DESCRIPTION OF SYMBOLS

| | | | |
|---|---|---|---|
| 100: | Smart distribution board | 200: | Energy management apparatus |
| 210: | Communication unit | 220: | Storage unit |
| 230: | Control unit | 240: | Data collection module |
| 250: | Estimation module | 260: | Visualization module |
| 300: | Energy management system | | |

## Claims

1. An energy management system for managing demand of power based on weather, fine dust, and power consumption data when small-scale demand management is required as expansion of electric vehicle supply and abrupt increase in demand for electricity in summer and winter are expected, and controlling and restoring an EMS relay for a circuit breaker for forced power supply of a consumer including apartments, buildings, and factories contracted with a power demand management business operator, the system comprising:
a smart distribution board including the EMS relay for controlling a circuit breaker for regular power supply that is installed at each consumer and is not cut off even when a power emergency situation occurs, and a circuit breaker for forced power supply that can be cut off when a power emergency situation occurs; and
an energy management apparatus for controlling the EMS relay of the smart distribution board when a power emergency situation occurs in order to accumulatively store power consumption data of each consumer and power reserve rate data by house and region, sequentially cut off power supplied to each consumer on the basis of the accumulated power consumption data and power reserve rate data when a power emergency situation occurs, and restore the EMS relay when the power emergency situation is resolved.

2. The system according to claim 1, wherein the energy management apparatus includes:
a communication unit for exchanging data with the smart distribution board;
a storage unit for storing the power consumption data and the power reserve rate data; and
a control unit for controlling the EMS relay of the smart distribution board through the communication unit when a power emergency situation occurs, in order to sequentially cut off power supplied to each consumer on the basis of the power consumption data stored in the storage unit, and restore the EMS relay when the power emergency situation is resolved.

3. The system according to claim 2, wherein the communication unit performs data transmission and reception with the smart distribution board through an IoT communication network.

4. The system according to claim 3, wherein the control unit collects and analyzes the power consumption data stored in the storage unit at preset intervals, processes and stores the power consumption data step by step in order of high power consumption by the type of each consumer, and controls each consumer step by step by the type by comparing the processed data with the power reserve rate in real time.

5. The system according to claim 2, wherein the control unit predicts a power cutoff priority of each consumer, a power cutoff priority of each consumer type, and a power cutoff priority of each region according to each consumer through an artificial intelligence engine trained using the power consumption data and the power reserve rate data stored in the storage unit, and sequentially cuts off power supplied to each consumer step by step according to one of the predicted cutoff priorities.

6. The system according to claim 1, wherein when the EMS relay of each consumer is controlled, the control unit transmits text of control details in real time to terminals possessed by residents, managers, and owners living in the control target consumer region, and transmits a blackout situation and the control details to a broadcasting company so that subtitles may be broadcasted.

7. An energy management method using an energy management system for managing demand of power based on weather, fine dust, and power consumption data when small-scale demand management is required as expansion of electric vehicle supply and abrupt increase in demand for electricity in summer and winter are expected, and controlling and restoring an EMS relay for a circuit breaker for forced power supply of a consumer including apartments, buildings, and factories contracted with a power demand management business operator, the method comprising the steps of:
accumulatively storing power consumption data of each consumer and power reserve rate data by house and region;
controlling EMS relays of smart distribution boards installed in a central power control system and a power management organization when a power emergency situation occurs, including EMS relays for controlling a circuit breaker for regular power supply that is installed at each consumer and is not cut off when a power emergency situation occurs and a circuit breaker for forced power supply that can be cut off when a power emergency situation occurs, in order to sequentially cut off power supplied to each consumer on the basis of the accumulated power consumption data and power reserve rate data; and
restoring the EMS relay when the power emergency situation is resolved.
